(19) Europäisches Patentamt / European Patent Office / Office européen des brevets

(11) **EP 2 962 328 B1**

(12) **EUROPÄISCHE PATENTSCHRIFT**

(45) Veröffentlichungstag und Bekanntmachung des Hinweises auf die Patenterteilung:
**09.02.2022 Patentblatt 2022/06**

(21) Anmeldenummer: **14719633.1**

(22) Anmeldetag: **19.02.2014**

(51) Internationale Patentklassifikation (IPC):
**H01L 23/367** (2006.01)    **H01L 21/48** (2006.01)

(52) Gemeinsame Patentklassifikation (CPC):
(C-Sets verfügbar)
**H01L 23/3677; H01L 21/4871; H01L 21/4882;**
H01L 2924/0002    (Forts.)

(86) Internationale Anmeldenummer:
**PCT/EP2014/053224**

(87) Internationale Veröffentlichungsnummer:
**WO 2014/131670 (04.09.2014 Gazette 2014/36)**

(54) **VERFAHREN ZUR HERSTELLUNG EINES KÜHLKÖRPERS UND KÜHLKÖRPER FÜR ELEKTRISCHE BAUTEILE**

METHOD FOR PRODUCING A HEAT SINK, AND HEAT SINK FOR ELECTRICAL COMPONENTS

PROCÉDÉ DE FABRICATION D'UN DISSIPATEUR THERMIQUE ET DISSIPATEUR THERMIQUE POUR DES COMPOSANTS ÉLECTRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.02.2013 AT 501232013**

(43) Veröffentlichungstag der Anmeldung:
**06.01.2016 Patentblatt 2016/01**

(73) Patentinhaber: **Neuman Aluminium Fliesspresswerk GmbH**
**72108 Rottenburg (DE)**

(72) Erfinder: **WOLFF, Roland**
**51503 Rösrath (DE)**

(74) Vertreter: **Wildhack & Jellinek Patentanwälte OG**
**Landstraßer Hauptstraße 50**
**1030 Wien (AT)**

(56) Entgegenhaltungen:
EP-A1- 1 898 684    WO-A1-03/051552
WO-A1-2010/041529    DE-A1- 10 014 459
JP-A- 2000 150 738    US-A1- 2011 132 968
US-A1- 2012 211 214    US-B1- 6 195 893

- GEIGER: "Umformen mit hohen hydrostatischen Druecken, hydrostatisches Strang- und Fließpressen", 1 January 1993 (1993-01-01), UMFORMTECHNIK HANDBUCH FUER INDUSTRIE UND WISSENSCHAFT,, PAGE(S) 47 - 79, XP008182471, pages 47-79, * paragraph [3.3.3] * * paragraph [3.7.2] *

(52) Gemeinsame Patentklassifikation (CPC): (Forts.)

C-Sets
H01L 2924/0002, H01L 2924/00

**Beschreibung**

Die Erfindung betrifft ein Verfahren zur Herstellung eines Kühlkörpers aus Aluminium mit einem Reinheitsgrad des Werkstoffes von größer als 99.0 Gew.-% Al zum Kühlen und zur Festlegung von elektronischen und/oder elektrischen Bauteilen, umfassend im Wesentlichen eine Grundplatte mit einerseits abragenden Kühlteilen und andererseits, diesen gegenüberliegend, mindestens eine Kontaktfläche zur thermischen Ankopplung von zu kühlenden Teilen.

Des Weiteren bezieht sich die Erfindung auf einen Kühlkörper aus Aluminium, mit einem Reinheitsgrad von größer als 99,0 Gew.-% zum Kühlen und zur Festlegung von elektronischen und/oder elektrischen Bauteilen, umfassend im Wesentlichen eine Grundplatte mit einerseits abragenden Kühlteilen und andererseits, diesen gegenüberliegend, mindestens eine Kontaktfläche zur thermischen Ankopplung von zu kühlenden Teilen.

Elektrische und elektronische Bauteile werden im steigenden Maße in Einrichtungen und Anlagen eingesetzt, wobei auch aus wirtschaftlichen Gründen und aus Gründen der Verkleinerung der Schaltanlagen sowie einer Betriebsart der Mikroprozessoren die Wärmeentwicklung steigt, sodass diese Bauteile in zunehmendem Maße in Kühlkörpern mit Kontaktflächen zur thermischen Ankopplung festgelegt werden.

Kühlkörper für eine Wärmeabfuhr von elektrischen Bauteilen sollen einerseits eine hohe Wärmeleitfähigkeit sowie geringe Wärmetransportwege aufweisen und andererseits eine günstige Oberflächenkontur zur Abgabe der Wärmeenergie an ein Kühlmittel haben.

Für einen Werkstoff für Kühlkörper haben sich Silber, Kupfer und Aluminium als günstig erwiesen, wobei aus wirtschaftlichen und Herstellungsgründen zumeist Aluminium mit einem hohen Reinheitsgrad Verwendung findet.

Kühlkörper werden im Wesentlichen zumeist aus einer Grundplatte mit einerseits abragenden Kühlteilen und diesen gegenüberliegend einer Kontaktfläche zur thermischen Ankopplung der zu kühlenden elektrischen Bauteile ausgeführt.

Für großflächige, intensiv zu kühlende Bauteile oder Baugruppen sind naturgemäß großflächige Kühlkörper erforderlich. Diese Kühlkörper sollen einerseits über die gesamte Kontaktfläche für die thermische Ankopplung der Bauelemente etwa die gleiche spezifische Wärmeabfuhrleistung aufweisen, um Bereiche mit höherer Temperatur (hot spots) auszuschalten und andererseits hohe Kühlintensität zu erbringen.

Diese Forderungen nach großen Kontaktflächen zur thermischen Ankopplung von Teilen mit hoher gleichmäßiger Kühlleistung der Kühlkörper bewirken Herstellprobleme derselben.

Die Druckschrift JP 2000 150 738 A beschreibt ein Verfahren zur Herstellung einer Wärmesenke und eine Wärmesenke mit einem Paar extrudierter Metallkammabschnitte mit Rippen, die auf einer Seite einer tafelförmigen Basis in einer Querrichtung der Basis installiert sind. Beide extrudierten Abschnitte werden durch Reibrührverbindung verbunden, bei der die Rühreinheit nicht die volle Fläche der Basis der Rippe einnimmt.

Großflächige gegossene Kühlkörper weisen zumeist eine Grobkorn-Mikrostruktur auf, sind nur aufwendig herstell- sowie bearbeitbar und haben im Vergleich mit Umgeformten ungünstige Wärmeleiteigenschaften.

Aus obigen Gründen werden derzeit zumeist nach dem Strang- oder Fließpressen (DIN 8583) hergestellte kleindimensionierte Kühlkörper für elektrische Bauteile eingesetzt.

Im Wesentlichen erfolgt ein Strangpressen durch Formgebung eines Rohteiles über der Rekristallisationstemperatur des Werkstoffes und ein Fließpressen von Einzelteilen bei etwa Raumtemperatur.

Kühlkörper nach obigem Pressverfahren haben neben wärmetechnischen Unterschieden den Nachteil, dass eine Herstellung von großflächigen Kontaktflächen nicht im ausreichenden bzw. gewünschten Maße möglich erscheint.

Hier will die Erfindung Abhilfe schaffen und setzt sich zum Ziel, ein Verfahren zur wirtschaftlichen Herstellung von Kühlkörpern anzugeben, welches eine hohe und gleichmäßige Wärmeabfuhr über große Kontaktflächen aufweist.

Weiters ist es Aufgabe der Erfindung, große, einteilige Kühlkörper mit gleichmäßig hohem Eigenschaftsprofil zu schaffen.

Das Ziel wird bei einem eingangs genannten Verfahren dadurch erreicht, dass in einem ersten Schritt aus einem Vormaterial durch Fließpressen bzw. durch Druckumformung bei einer Temperatur unterhalb der Rekristallisationstemperatur gemäß DIN 8583 Einzelsegmentplatten für eine Grundplatte bei Ausformung der von dieser abragenden Kühlteile bei Bildung einer Verformungstextur zumindest in Teilbereichen hergestellt, diese Einzelsegmentplatten örtlich spanabhebend bearbeitet und nach einem Bearbeiten der Seitenflächen der Einzelsegmentplatten derart aneinander angelegt, aufgespannt und zu einer Grundplatte gefügt werden, dass die im Bereich der Verbindung der Einzelsegmente abragenden Kühlteile) einen im Wesentlichen gleichen für eine Funktion der Wärmeableitung wirksamen Axabstand wie an den Einzelsegmenten selbst aufweisen, worauf in einem zweiten Schritt mindestens zwei Einzelsegmentplatten bei gleichsinnig abragenden Kühlteilen schmelzfrei, metallisch krummflächig mit einer Feinkornstruktur miteinander verbunden werden, worauf in einem Folgeschritt eine Endbearbeitung des aus mehreren Einzelsegmenten erstellten großflächigen Kühlkörpers mit einer Ausbildung der Kontaktfläche(n) zur thermischen Ankopplung von Bauteilen an der Grundplatte erfolgt.

In vorteilhafter Weise wird dadurch eine metallische, feinkörnige, gute Wärmeleitungseigenschaften aufweisende Verbindung von Einzelsegmenten miteinander erreicht.

Die Feinkornstruktur der Verbindung bewirkt, wie überraschend gefunden wurde, eine hohe Wärmeleitfähigkeit des reinen Aluminiumwerkstoffes, obwohl eine Feinkörnigkeit des Materials in der Regel zu einer geringeren Temperaturleitfähigkeit führt.

Derartige Technologien einer schmelzfrei hergestellten, metallischen Verbindung sind per se bekannt, jedoch wurde festgestellt, dass für eine verzugsarme Fertigung von Kühlkörpern aus mehreren Teilen mit der Ausformung von großen Kontaktflächen dieses Fügeverfahren wirtschaftliche Vorteile und insbesondere für eine Wärmeableitung von elektrischen Bauteilen eine günstige Wirkung mit sich bringt.

Von besonderem Vorteil im Hinblick auf eine erhöhte Wärmeabfuhr von der Kontaktfläche des Kühlkörpers hat sich beim erfindungsgemäßen Verfahren eine Vergrößerung der Oberfläche der Kühlteile mit verbesserter Wärmeleitung im Kühlkörper selbst herausgestellt, bei welchem im ersten Schritt Einzelsegmentplatten mit Kühlstiften durch Fließpressen von Vormaterial bei einer Bildung einer Verformungstextur zumindest im Teilbereichen derselben erfolgt.

Diese besonders günstige Ausführungsform eines Kühlkörpers wird mittels eines verbesserten Wärmeflusses in den Einzelsegmentplatten und mit einer Vergrößerung der Wärmeabgabe durch die eine größere Oberfläche aufweisenden Kühlstifte erreicht.

Als besonders günstig hat sich ein Fügen von fließgepressten Segmenten herausgestellt, wenn die schmelzfrei metallische Verbindung der Seitenfläche(n) von Einzelsegmenten zu einer Grundplatte durch ein Reibrührschweißen, einem sogenannten "friction stir welding"-Verfahren, unter Ausschluss von Zusatzwerkstoffen hergestellt wird.

Eine derartig hergestellte, feinkörnige, krummflächige Verbindung wirkt sich vorteilhaft auf den Wärmetransport zwischen den Einzelsegmenten aus, verbessert die Homogenität der Temperaturverteilung an der Kontaktfläche der Grundplatte und minimiert deren Verzug auch bei extremen thermischen Belastungen.

Dieser überraschende Effekt beruht offenbar auf einer Verbesserung des Wärmetransportes, obwohl eine Feinkörnigkeit des Werkstoffes nach Fachmeinung eine Temperaturleitung behindert.

Wenn, wie sich gezeigt hat, nach einem Bearbeiten, die Seitenflächen der Einzelsegmente derart aneinander angelegt, aufgespannt und schmelzfrei metallisch zu einer Grundplatte gefügt werden, dass die im Bereich der metallischen Verbindung der Einzelsegmente abragenden Kühlteile einen im Wesentlichen für eine Funktion der Wärmeableitung gleichen Axabstand wie an den Segmenten selbst aufweisen, wird an der Kontaktfläche eine höchst gleichmäßige Temperaturverteilung bei homogener Wärmebeaufschlagung erreicht.

Die weitere Aufgabe der Erfindung wird bei einem gattungsgemäßen Kühlkörper dadurch erreicht, dass *der* Kühlkörper eine Kontaktfläche mit einer Größe von insgesamt mehr als 145 mm x145 mm bzw. 0,021 m$^2$ bei einer Dicke der Grundplatte von 4 mm bis 30 mm aufweist, aus fließgepressten Einzelsegmentplatten mit einseitig abragenden Kühlteilen, vorzugsweise im Wesentlichen runden Kühlstiften und zumindest teilweise mit einer Verformungstextur des Werkstoffes im Übergangsbereich von der Einzelsegmentplatte in die Kühlstifte gebildet ist, welche Einzelsegmenplatten miteinander krummflächig mit Feinkornstruktur metallisch zusatzwerkstofffrei die Grundplatte bildend verbunden sind, wobei über die Gesamtfläche der Grundplatte der wirksame Axabstand der gleichgerichtet abragenden Kühlstifte im Wesentlichen konstant ist.

$$X_0 = \frac{X + X'}{2}$$

Xo= wirksamer Abstand der Kühlstifte
X = Axabstand der Kühlstifte in einer Reihe
X'= Axabstand der Kühlstifte in einer weiteren Reihe der Kühlstifte

Auch bei einer instationären, thermischen Belastung des Kühlkörpers durch eine von der momentanen Beaufschlagung abhängige Abgabe von Wärmeenergie der elektrischen Bauteile an die Kontaktfläche bleiben Verzugserscheinungen aus.

Mit Vorteil sind die Einzelsegmentplatten mittels Fließpressverfahrens mit Kühlstiften hergestellt und weisen zumindest teilweise eine Verformungstextur auf.

Weil bei einem Fließpressverfahren der Einzelsegmente das Vormaterial bei im Wesentlichen Raumtemperatur in eine Matrize eingepresst wird, bildet sich im Werkstoff eine Verformungstextur aus, welche, wie gefunden wurde, der Wärmeleitung förderlich ist. Weiters wird erfindungsgemäß durch eine entsprechende Ausbildung der Kühlstifte die Wärmeabgabe an ein Kühlmedium, beispielsweise strömende Luft, intensiviert.

Für ein Fügen ist von Vorteil, wenn die schmelzfrei metallische Verbindung der Seitenflächen der Einzelsegmentplatten durch ein Reibrührschweißen, ein sogenanntes "friction stir welding"-Verfahren erstellt ist. Dieses per se bekannte Verfahren hat für eine Wärmeleitung zwischen den Einzelsegmentplatten aufgrund eines mehrfach gekrümmten, feinkörnigen Bindebereichs erfindungsgemäß den Vorteil einer Vergleichmäßigung der Temperatur der Kontaktfläche des Kühlkörpers. Es hat sich weiters für einen Wärmetransport und eine Bruchsicherheit als günstig erwiesen, wenn eine Verformungstextur des Werkstoffes zumindest im Übergangsbereich von der Grundplatte in die Kühlstifte vorliegt.

Wenn nach Ausführungsform der Erfindung die im Bereich der metallischen Verbindung der Einzelsegmente abragenden Kühlteile einen im Wesentlichen gleichen, für eine Funktion der Wärmeableitung wirksamen Axabstand wie derjenige, der innerhalb der Einzelsegmente vorliegt, aufweisen, wird erfindungsgemäß eine besonders gleichmäßige Wärmeableitung von der Kontaktfläche des Kühlkörpers erreicht.

Als besonders effizient hat sich die Erfindung für Kühlkörper mit einer Kontaktfläche zur thermischen Ankopplung von Bauteilen von größer 130 x 130 mm, bei einer Dicke der Grundplatte von 4 bis 30 mm, erwiesen.

Mit einer Ausführungsvariante, bei welcher die Kühlstifte einen größten wirksamen Abstand von (2 bis 4)mal von deren mittleren Durchmesser aufweisen, die Grundplatte eine Dicke von (0.8 bis 1.5)mal den wirksamen Axabstand der Kühlstifte hat und die maximale Auskraglänge der Kühlstifte (6 bis 8)mal von deren mittleren Durchmesser beträgt, wurden bei den bisherigen Untersuchungen die besten Ergebnisse ermittelt.

Im Folgenden soll die Erfindung anhand von Darstellungen, die allenfalls nur einen Ausführungsweg zeigen, näher erläutert werden.

Es zeigen

Fig. 1 Schemazeichnung eines Kühlkörpers im Schnitt AA *von Fig.2*

Fig. 2 Schemazeichnung eines Kühlkörpers in Draufsicht

Fig. 3 Einzelsegmentplatte mit Kühlstiften (Stand der Technik)

Fig. 4 Einzelsegmentplatte mit Kontaktfläche ( Stand der Technik)

Fig. 5 Einzelsegmentplatten mit den Seitenflächen aneinander anliegend

Fig. 6 Prinzipskizze einer schmelzfrei metallischen Verbindung

Fig. 7 Schmelzfrei metallische Verbindung von Einzelsegmentplatten (Verfahrensentwicklung)

Zur leichteren Zuordnung der Teile und Komponenten eines erfindungsgemäßen Kühlkörpers soll die nachfolgende Bezugszeichenliste dienen:

1 Kühlkörper
2 Grundplatte
21 Einzelsegmentplatte
22 Seitenflächen
23 Kühlteile
24 Kühlstifte
25 Kontaktfläche
V Verformungstextur
R Reibrührschweißen
M metallische Verbindung
$X_0$ wirksamer Axabstand der (Kühlteile) Kühlstifte
X,X' Axabstand der Kühlstifte zu benachbarten Kühlstiften
D Durchmesser der Kühlstifte
H Grundplattendicke
L Auskraglänge der Kühlstifte

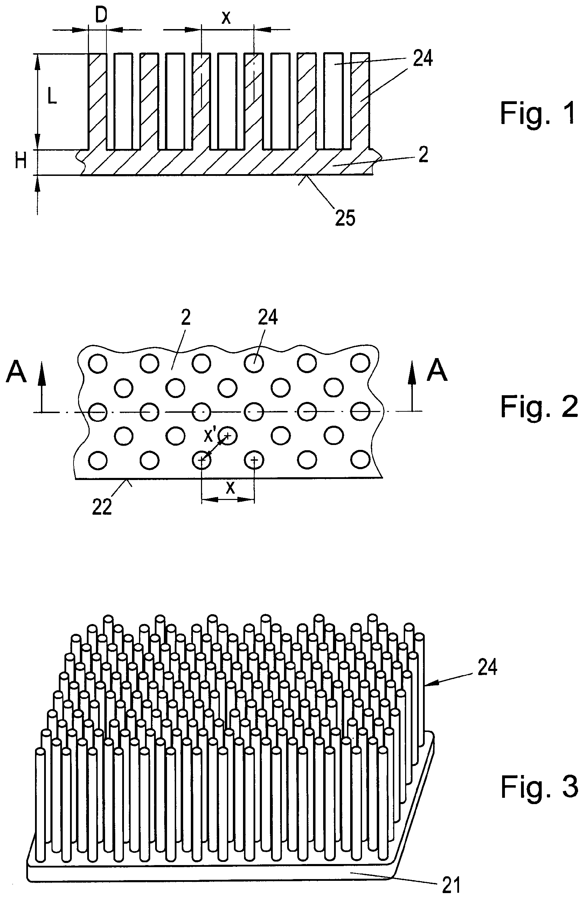

Fig. 1 zeigt schematisch einen Schnitt durch einen Kühlkörper 1 in einer Position **AA** von Fig. 2.

Auf einer Grundplatte **2** mit einer Dicke **H** sind Kühlstifte **24** mit einem Durchmesser **D** in einem Axabstand **X** zueinander und einer Länge **L** ausgeformt.

Wie in Fig. 2 dargestellt ist, kann ein Axabstand **X** in einer Reihe ungleich demjenigen **X'** in einer weiteren Reihe von Kühlstiften **24** bemessen sein. Für eine Funktion der Wärmeableitung von einer Kühlfläche **25** ist jedoch ein wirksamer Axabstand $X_0$ der Kühlstifte relevant, welcher sich aus dem größten Axabstand **X** plus dem kleinsten Axabstand **X'** der Kühlstifte **24** jeweils zu einem benachbarten Kühlstift **24** gebrochen durch **2** ergibt.

$$X_0 = \frac{X + X'}{2}$$

In Fig. 2 ist auch die auf Maß bearbeitete Seitenfläche **22** dargestellt.

Fig. 3 zeigt eine Einzelsegmentplatte **21** mit abragenden Kühlstiften **24.**

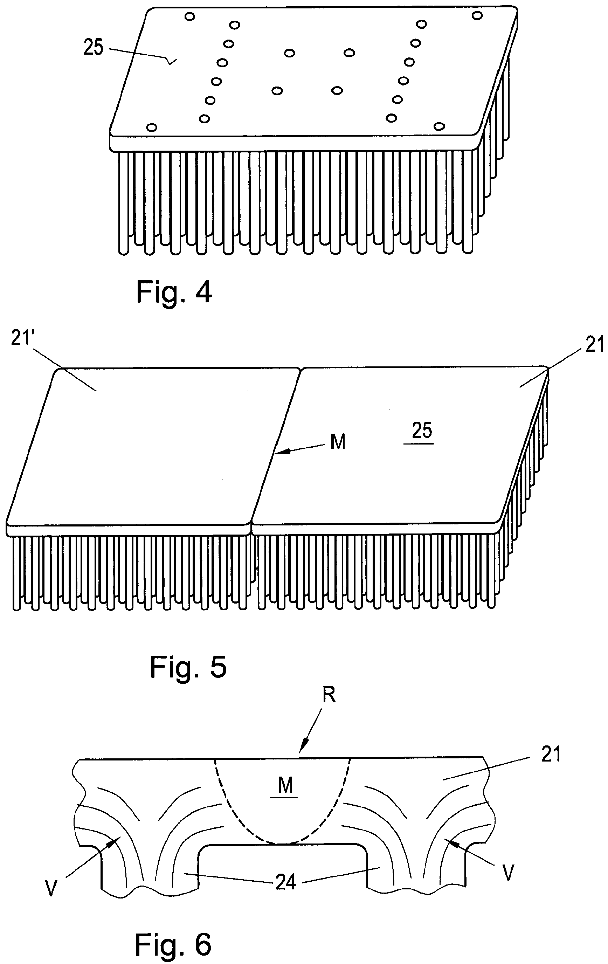

Fig. 4 veranschaulicht dieselbe Einzelsegmentplatte **21** mit Ansicht der Kontaktfläche **25.**

In Fig. 5 sind zwei Einzelsegmentplatten **21, 21'** bei gleichsinnig abragenden Kühlstiften **24** mit den Seitenflächen **22** aneinander anliegend aufgespannt. Die Seitenflächen werden zur Erzielung einer metallischen Verbindung **M** schmelzfrei durch Reibrührschweißen bearbeitet.

Fig. 6 zeigt schematisch bzw. anhand einer Skizze durch Fließpressen hergestellt Einzelsegmentplatten **21, 21'**, welche durch eine schmelzfrei metallische Verbindung **M** zu einer Grundplatte **2** gefügt sind. Weiters ist in Fig. 6 eine Verformungstextur **V,** welche durch ein Fließpressen eines Vormaterials bei Raumtemperatur gebildet wurde, dargestellt.

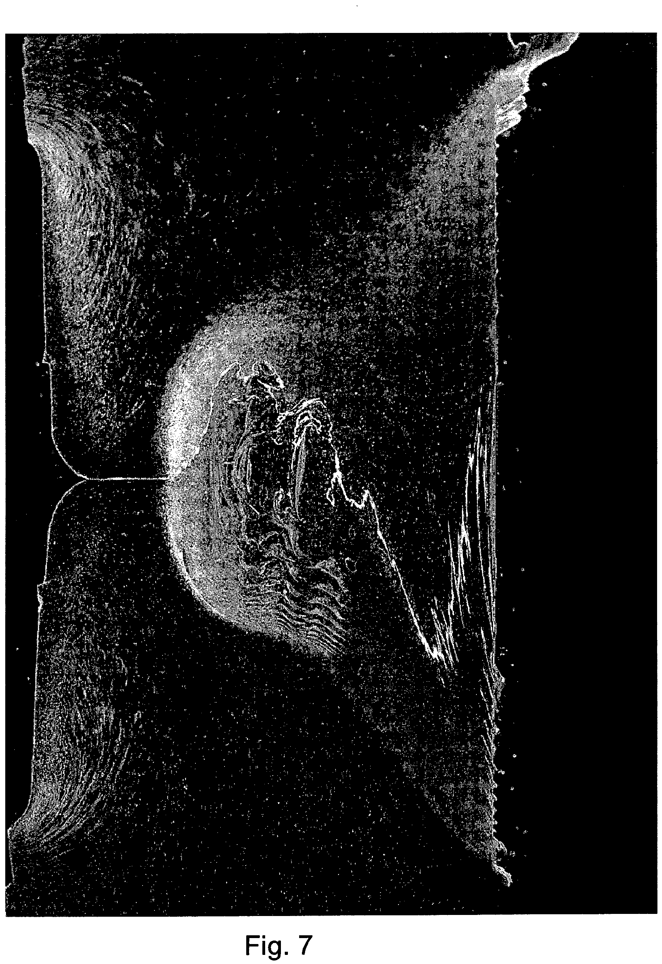

In Fig. 7 ist an einem geätzten Schnittbild von den Entwicklungsarbeiten des anmeldungsgemäßen Gegenstandes eine durch Reibrührschweißen erzielte, nicht vollkommen durchgehende feinkörnige Verbindung **M** von Einzelsegmentplatten **21, 21'**gezeigt. Eine nur teilweise erfolgte schmelzfreie Verbindung **H** wurde durch eine unzureichende Werkzeuggeometrie des Reibmittels bewirkt.

Im Bereich der Übergänge der Kühlstifte **24** in die Einzelsegmentplatten **21,21'** sind am Ätzbild Verformungstexturen **V** deutlich zu erkennen.

Versuche mit einem Verfahren zur Herstellung eines Kühlkörpers gemäß der Erfindung aus Kupfer oder aus Kupferlegierungen haben überraschend positive Ergebnisse erbracht, welche in der Folge im irr Einzelnen noch untersucht werden.

**Patentansprüche**

**1.** Verfahren zur Herstellung eines Kühlkörpers (1) aus Aluminium mit einem Reinheitsgrad von größer als

99.0 Gew.-% Al zum Kühlen und zur Festlegung von elektronischen und/oder elektrischen Bauteilen, umfassend im Wesentlichen eine Grundplatte (2) mit einerseits abragenden Kühlteilen (23) und andererseits, diesen gegenüberliegend, mindestens eine Kontaktfläche (25) zur thermischen Ankopplung von zu kühlenden Teilen, **dadurch gekennzeichnet, dass** in einem ersten Schritt aus einem Vormaterial durch Fließpressen bzw. Druckumformen bei einer Temperatur unterhalb der Rekristallisationstemperatur gemäß DIN 8583 Einzelsegmentplatten (21) für eine Grundplatte (2), bei Ausformung der von diesen abragenden Kühlteile (23) bei Bildung einer Verformungstextur (V) zumindest in Teilbereichen hergestellt, diese Einzelsegmentplatten (21) örtlich spanabhebend bearbeitet werden und nach einem Bearbeiten der Seitenflächen (22) der Einzelsegmentplatten (21) derart aneinander angelegt, aufgespannt und zu einer Grundplatte (2) gefügt werden, dass die im Bereich der Verbindung (M) der Einzelsegmente (21) abragenden Kühlteile (23) einen im Wesentlichen gleichen für eine Funktion der Wärmeableitung wirksamen Axabstand ($X_0$) wie an den Einzelsegmenten (21) selbst aufweisen, worauf in einem zweiten Schritt mindestens zwei Einzelsegmentplatten (21) bei gleichsinnig abragenden Kühlteilen (23) schmelzfrei metallisch (M) krummflächig mit einer Feinkornstruktur (R) miteinander verbunden werden, worauf in einem Folgeschritt eine Endbearbeitung des aus mehreren Einzelsegmenten (21,21') erstellten großflächigen Kühlkörpers (1) mit einer Ausbildung der Kontaktfläche(n) (25) zur thermischen Ankoppelung von Bauteilen an der Grundplatte (2) erfolgt.

2. Verfahren nach Anspruch 1, **dadurch gekennzeichnet, dass** die abragenden Kühlteile (23) als im Querschnitt im Wesentlichen runde Kühlstifte (24) gebildet werden..

3. Verfahren nach Anspruch 1 oder 2, **dadurch gekennzeichnet, dass** die im zweiten Schritt schmelzfrei krummflächig mit einer Feinkornstruktur erstellte metallische Verbindung (M) von mindestens zwei Einzelsegmentplatten (21, 21') zu einer Grundplatte (2) durch ein Reibrührschweißen, einem fachlich sogenannten "friction stir welding"- Verfahren unter Ausschluss von Zusatzwerkstoffen hergestellt wird..

4. Kühlkörper (1) aus Aluminium mit einem Reinheitsgrad des Werkstoffes von als 99.0 Gew.-% Al für eine Kühlung und eine Festlegung von elektronischen und/oder elektrischen Bauteilen, umfassend im Wesentlichen eine Grundplatte (2) mit einerseits abragenden Kühlteilen (23) und andererseits, diesen gegenüberliegend, mindestens eine Kontaktfläche (25) zur thermischen Ankopplung von zu kühlenden Teilen, **dadurch gekennzeichnet, dass** der Kühlkörper (1) eine Kontaktfläche (25) mit einer Größe von insgesamt mehr als 145 mm x 145 mm bzw. 0,021 m$^2$ bei einer Dicke (H) der Grundplatte (2) von 4 mm bis 30 mm aufweist, aus fließgepressten Einzelsegmentplatten (21) mit einseitig abragenden Kühlteilen (23), vorzugsweise im Wesentlichen runden Kühlstiften (24) und zumindest teilweise mit einer Verformungstextur (V) des Werkstoffes im Übergangsbereich von der Einzelsegmentplatte (21) in die Kühlstifte (24) gebildet ist, welche Einzelsegmentplatten (21) miteinander krummflächig (R) mit Feinkornstruktur metallisch zusatzwerkstofffrei die Grundplatte (2) bildend verbunden sind, wobei über die Gesamtfläche der Grundplatte (2) der wirksame Axabstand ($X_0$) der gleichgerichtet abragenden Kühlstifte (24) im Wesentlichen konstant ist.

$$X_0 = \frac{X + X'}{2}$$

$X_0$ = wirksamer Abstand der Kühlstifte
$X$ = Axabstand der Kühlstifte in einer Reihe
$X'$ = Axabstand der Kühlstifte in einer weiteren Reihe der Kühlstifte

5. Kühlkörper nach Anspruch 4, **dadurch gekennzeichnet, dass** die schmelzfreie metallische Verbindung (M) der Seitenflächen (22) der Einzelsegmentplatten (21) durch ein Reibrührschweißen einem in der Fachwelt sogenannten "friction stir welding"-Verfahren, erstellt ist.

6. Kühlkörper nach Anspruch 1 oder 2, **dadurch gekennzeichnet, dass** die Kühlstifte (24) einen größten wirksamen Axabstand ($X_0$) von 2mal bis 4mal dem mittleren Durchmesser (D) derselben aufweisen und die Grundplatte (2) eine Dicke (H) von 0,8mal bis 1,5mal dem wirksamen Axabstand ($X_0$) der Kühlstifte (24) hat, wobei die maximale Auskraglänge (L) der Kühlstifte (24) 6mal bis 8mal des mittleren Durchmessers (D) beträgt.

**Claims**

1. Method for producing a heat sink (1) from aluminium with a degree of purity of greater than 99.0 wt% Al for cooling and for fixing electronic and/or electrical components, comprising substantially a base plate (2) with cooling parts (23) protruding on one side and on the other side, opposite thereto, at least one contact surface (25) for the thermal coupling of parts to be cooled, **characterised in that** in a first step individual segment plates (21) are produced from a prematerial, by means of impact extrusion or pressure forming at a temperature below the recrystallisation temperature according to DIN 8583, for a base plate (2), the cooling parts (23) protruding therefrom being formed with a deforming texture (V) being formed at least in partial regions, these individual segment plates (21) are processed locally with material removal, and, after a processing of the side surfaces (22) of these segment plates (21), are laid against one another, tensioned and joined to form a base plate (2) such that the cooling parts (23) protruding in the region of the connection (M) of the individual segments (21) have a substantially identical axial spacing ($X_0$) effective for a function of the heat discharge as at the individual segments (21) themselves, whereafter in a second step at least two individual segment plates (21) with cooling parts (23) protruding in identical manner are connected in a melt-free manner metallically (M) with a curved surface with a fine-grained structure (R) to one another, after which in a following step an end processing takes place of the large-surface heat sink (1) produced from a plurality of individual segments (21, 21') , with a formation of the contact surface(s) (25) for thermal coupling of components to the base plate (2).

2. Method according to claim 1, **characterised in that** the protruding cooling parts are in the form of cooling pins (24) which are substantially round in cross-section.

3. Method according to claim 1 or 2, **characterised in that** the metallic connection (M), created in the second step in a melt-free manner with a curved surface with a fine-grained structure, of at least two individual segment plates (21, 21') to form a base plate (2) is produced in a friction stir welding method without the inclusion of additional materials.

4. Heat sink (1) made of aluminium with a degree of purity of the material of than 99.0 wt% Al for a cooling and a fixing of electronic and/or electric components, comprising substantially a base plate (2) with cooling parts (23) protruding on one side and on the other side, opposite thereto, at least one contact surface (25) for the thermal coupling of parts to be cooled, **characterised in that** the heat sink (1) has a contact surface (25) with a size of in total more than 145 mm x 145 mm or 0.021 m$^2$ with a thickness (H) of the base plate (2) of 4 mm to 30 mm, is made of impact extruded individual segment plates (21) with cooling parts (23) protruding on one side, preferably substantially round cooling pins (24), and is formed at least partially with a deforming texture (V) of the material in the transition region from the individual segment plate (21) into the cooling pins (24), which individual segment plates (21) are connected in a curved-surface manner (R) with a fine-grained structure metallically without additional material, forming the base plate (2), wherein across the entire surface of the base plate (2) the effective axial spacing ($X_0$) of the cooling pins (24) protruding in the same direction is substantially constant.

$$X_0 = \frac{X + X'}{2}$$

$X_0$ = effective spacing of the cooling pins
$X$ = axial spacing of the cooling pins in a row
$X'$ = axial spacing of the cooling pins in a further row of the cooling pins

5. Heat sink according to claim 4, **characterised in that** the melt-free metallic connection (M) of the side surfaces (22) of the individual segment plates (21) is created by a friction stir welding method.

6. Heat sink according to claim 1 or 2, **characterised in that** the cooling pins (24) have a greatest effective axial spacing ($X_0$) of twice to four times the average diameter (D) of the same and the base plate (2) has a thickness (H) of 0.8 times to 1.5 times the effective axial spacing ($X_0$) of the cooling pins (24), wherein the maximum protrusion length (L) of the cooling pins (24) is six times to eight times the average diameter (D).

**Revendications**

1. Procédé de fabrication d'un dissipateur thermique (1) en aluminium présentant un degré de pureté supérieur à 99,0 % en poids d'Al pour un refroidissement et une fixation de composants électroniques et/ou électriques, comprenant essentiellement une plaque de base (2) avec, d'une part, des parties de refroidissement (23) faisant saillie et, d'autre part, au moins une surface de contact (25) opposée à celles-ci, pour un couplage thermique de pièces à refroidir, **caractérisé en ce que,** dans une première étape, des plaques de segment individuel (21) pour une plaque de base (2) sont fabriquées à partir d'un produit de départ par extrusion ou formage sous pression à une température inférieure à la température de recristallisation conformément à la norme DIN 8583, par formage des parties de refroidissement (23) faisant saillie à partir de celles-ci par formation d'une texture de déformation (V), au moins par endroits, ces plaques de segment individuel (21) sont usinées par enlèvement de copeaux localement et, après usinage des surfaces latérales (22) des plaques de segment individuel (21), sont placées les unes contre les autres, serrées et assemblées pour former une plaque de base (2), **en ce que** les parties de refroidissement (23) faisant saillie dans la zone de la liaison (M) des segments individuels (21) présentent une distance axiale ($X_0$) sensiblement iden-

tique pour une fonction de dissipation de chaleur comme au niveau des segments individuels (21) eux-mêmes, après quoi, dans une seconde étape, au moins deux plaques de segment individuel (21), avec des parties de refroidissement (23) faisant saillie dans la même direction, sont reliées mutuellement d'une manière métallique sans fusion (M) avec une structure à grains fins (R) sous la forme d'une surface incurvée, après quoi, dans une étape ultérieure, un usinage final du dissipateur thermique de grande surface (1) produit à partir de plusieurs segments individuels (21, 21') est effectué, avec une conception de la ou des surfaces de contact (25) pour un couplage thermique de composants à la plaque de base (2).

2. Procédé selon la revendication 1, **caractérisé en ce que** les parties de refroidissement (23) faisant saillies sont réalisées sous forme de broches de refroidissement (24) qui présentent une section transversale essentiellement ronde.

3. Procédé selon la revendication 1 ou 2, **caractérisé en ce que** la liaison métallique (M), réalisée dans la deuxième étape sans fusion et avec une structure à grains fins, sous la forme d'une surface incurvée, d'au moins deux plaques de segment individuel (21, 21') pour former une plaque de base (2) est réalisée par un procédé dit de « soudage par friction-malaxage » à l'exclusion des matières de remplissage.

4. Dissipateur thermique (1) en aluminium présentant un degré de pureté du matériau de 99,0 % en poids d'Al pour un refroidissement et une fixation de composants électroniques et/ou électriques, comprenant d'une part essentiellement une plaque de base (2) avec des parties de refroidissement faisant saillie (23), et d'autre part au moins une surface de contact (25) opposée à celles-ci pour un couplage thermique de pièces à refroidir, **caractérisé en ce que** le dissipateur thermique (1) présente une surface de contact (25) présentant une dimension totale supérieure à 145 mm x 145 mm ou 0,021 m$^2$ avec une épaisseur (H) de la plaque de base (2) de 4 mm à 30 mm, constituée de plaques de segment individuel extrudées (21) avec des parties de refroidissement faisant saillie (23) d'un côté, de préférence essentiellement des broches de refroidissement rondes (24) et au moins partiellement avec une texture de déformation (V) du matériau dans la zone de transition de la plaque de segment individuel (21) aux broches de refroidissement (24), lesquelles plaques de segment individuel (21) sont reliées entre elles de telle sorte qu'elles forment la plaque de base (2) sous la forme d'une surface incurvée avec une structure à grains fins (R) sans additif métallique, l'espacement axial ($X_0$) des broches de refroidissement faisant saillie (24) dans la même direction de base (2) étant essentiellement constant sur toute la plaque de base (2),

$$X_0 = \frac{X + X\prime}{2}$$

$X_0$ = distance effective des broches de refroidissement
X = distance axiale des broches de refroidissement dans une rangée
X' = distance axiale des broches de refroidissement dans une rangée supplémentaire de broches de refroidissement.

5. Dissipateur thermique selon la revendication 4, **caractérisé en ce que** la liaison métallique (M) sans fusion des surfaces latérales (22) des plaques de segment individuel (21) est réalisée par soudage par friction-malaxage selon un procédé de soudage par friction-malaxage connu de l'homme du métier.

6. Dissipateur thermique selon la revendication 1 ou 2, **caractérisé en ce que** les broches de refroidissement (24) présentent une distance axiale effective maximale ($X_0$) de 2 à 4 fois leur diamètre moyen (D) et la plaque de base (2) présente une épaisseur (H) de 0,8 à 1,5 fois la distance axiale effective ($X_0$) des broches de refroidissement (24), la longueur de saillie maximale (L) des broches de refroidissement (24) étant de 6 à 8 fois le diamètre moyen (D).

Fig. 1

Fig. 2

Fig. 3

25

## Fig. 4

21'    21

M    25

## Fig. 5

R

M

21

V    24    V

## Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2000150738 A